# EUROPÄISCHE PATENTSCHRIFT

(11) **EP 2 421 343 B1**
(45) Veröffentlichungstag und Bekanntmachung des Hinweises auf die Patenterteilung: **20.03.2013**
(21) Anmeldenummer: 10172160.3
(22) Anmeldetag: 06.08.2010
(51) Int. Cl.: H05K 3/40, H05K 3/00, H05K 3/12

(54) **Anlage und Verfahren zum Bearbeiten von Leiterplatten**
Assembly and method for machining circuit boards
Installation et procédé destinés à traiter des plaquettes

(43) Veröffentlichungstag der Anmeldung: 22.02.2012
(73) Patentinhaber: Mass GmbH, 59590 Geseke (DE)
(72) Erfinder: Klocke, Franz, 59590 Geseke (DE); Settemeyer, Axel, 33175 Bad Lippspringe (DE)
(74) Vertreter: Reimann, Silke

(56) Entgegenhaltungen:
- DE-A1- 10 222 874
- US-A1- 2003 170 387
- US-B1- 6 398 099

## Beschreibung

Die Erfindung betrifft eine Anlage zum Bearbeiten von Leiterplatten, die das Füllen von eingebrachten Löchern mit einem Füllmaterial oder das Auftragen von Auftragsmaterial erlaubt, umfassend eine Haltevorrichtung zum Halten der Leiterplatte, ein Füllteil zum Einbringen des Füll- oder Auftragsmaterials und ein auf der dem Füllteil gegenüberliegenden Seite der Leiterplatte befindliches Gegenhalteteil, wobei das Füllteil über die Leiterplatte bewegbar ist und dabei, abgedichtet an einer Seite der Leiterplatte anliegend, die auf der Leiterplatte vorgesehenen Bearbeitungsbereiche unter Pressdruck bearbeitet,.

Bei der Herstellung von mehrschichtigen Leiterplatten werden in diesen zur Kontaktherstellung zwischen den einzelnen Schichten Löcher ausgebildet, welche dann mit einem leitfähigen Material ausgefüllt werden oder zur Einsparung eines solchen Materials z. B. nur an ihren Umfangswänden metallisch beschichtet und anschließend mit kostengünstigerem Material, wie z. B. Epoxydharz, wieder verschlossen werden. Das Schließen der Löcher wird vorgenommen, um die Gesamtfläche zu minimieren. So können z. B. auf einer wieder aufgefüllten Bohrung Anlötsockel Pads für an die Leiterplatte anzuschließende Bauteile, wie z. B. Transistoren, IC's etc., angeordnet werden. Es kann auch ein Loch in einer Zwischenlage genutzt werden, um eine elektrische Verbindung beider Seiten dieser Zwischenlage herzustellen, wobei dann nach dem Verfüllen dieses Lochs die gleiche Fläche für eine kleinere Bohrung wieder benutzt werden kann, um beispielsweise eine Kontaktverbindung zwischen weiter außen gelegenen Leiterplattenlagen herzustellen.

Aus der Patentschrift DE 102 22 874 B4 ist eine Füllanlage zum luftblasenfreien Füllen von in Leiterplatten eingebrachten Löchern mit einem Füllmaterial bekannt. Die dort beschriebene Füllanlage füllt die Löcher einer vertikal gehaltenen Leiterplatte mit einem Füllkopf und einem auf der gegenüberliegenden Seite der Leiterplatte befindlichen Abstreifrakel. Das Füllen erfolgt grundsätzlich unter Vakuum

Aus der Patentanmeldung US 2003/170387 A1 (vgl. den Oberbegriff des Anspruchs 1) ist eine Anlage zum Bearbeiten von Leiterplatten bekannt, die das Füllen von Löchern einer waagerecht liegenden Leiterplatte mit einem Füllmaterial über Pressdruck durch eine Schablone erlaubt. Als Gegenhalteteil beim Füllen ist nur ein Rakel vorgesehen, so dass sich die Leiterplatte durch den Pressdruck durchbiegen und damit die Füllung an Präzision verlieren kann.

Ebenso ist aus der Patentschrift US 6,398,099 B1 eine Anlage zum Bearbeiten von Leiterplatten bekannt, die das Füllen von Löchern einer waagerecht liegenden Leiterplatte mit einem Füllmaterial über Pressdruck durch eine Schablone erlaubt. Es ist eine geschlossene Kammer vorgesehen, in der eine beheizbare Basisplatte die Auflage für eine zu füllende Leiterplatte bietet. Die Blasenbildung im Füllmaterial wird über den Innendruck der Kammer gesteuert.

Weiterhin sind Siebdruckanlagen bekannt, mit denen Lotpaste mittels eines Rakels auf Lötstellen einer Leiterplatte aufgetragen wird.

Es ist die Aufgabe der Erfindung, eine Anlage zu offenbaren, die es erlaubt die Löcher einer Leiterplatte in der waagerechten Lage zu füllen und bei der die Durchgangslöcher auch unter normalem Luftdruck gefüllt werden können sowie auch Pasten auf Auftragsbereiche aufgetragen werden können.

Diese Aufgabe wird durch eine Anlage mit den Merkmalen des Anspruchs 1 gelöst. Ein Verfahren zum Bearbeiten einer Leiterplatte mit einer solchen Anlage ist in Anspruch 10 beschrieben. Vorteilhafte Ausgestaltungen der Erfindung sind in den abhängigen Ansprüchen angegeben.

Die Anlage zum Bearbeiten von Leiterplatten, die das Füllen von eingebrachten Löchern mit einem Füllmaterial oder das Auftragen von Auftragsmaterial erlaubt, umfasst eine Haltevorrichtung zum Halten der Leiterplatte, ein Füllteil zum Einbringen des Füllmaterials und ein auf der dem Füllteil gegenüberliegenden Seite der Leiterplatte befindliches Gegenhalteteil auf.

Das Füllteil ist über der Leiterplatte bewegbar und bearbeitet dabei, abgedichtet an einer Seite der Leiterplatte anliegend, die auf der Leiterplatte vorgesehenen Bearbeitungsbereiche unter Pressdruck.

Die Leiterplatte ist waagerecht in der Halteeinrichtung gehalten und auf der Leiterplatte liegt eine Schablone, die die bei den Bearbeitungsbereichen Öffnungen aufweist, so dass nur die durch die Öffnungen freiliegenden Löcher oder Auftragbereiche gefüllt werden.

Bevorzugt ist ein Füllteil vorgesehen, das einen Hohlkörper besitzt, der zur Aufnahme des Füllmaterials vorgesehen ist, und der eine oder mehrere Ausgangsöffnungen aufweist. Um die Ausgangsöffnungen ist eine umgebende Dichtung vorgesehen, mittels welcher das Füllteil den Zwischenraum zwischen der/den Ausgangsöffnungen und der Schablone abdichtet. Über ein solches Füllteil kann dann das Füll- oder Auftragsmaterial durch die Ausgangsöffnung in den von der Dichtung um die Ausgangsöffnungen herum ausgebildeten Zwischenraum gepresst werden, wobei nach Ausfüllen dieses Zwischenraums dann das Füllmaterial weiter in die Löcher gepresst wird. Durch Bewegen des Füllteils über die Platte hinweg können dann alle vorhandenen Löcher ausgefüllt werden. Die Dichtung dient hierbei auf der dem Füllteil zugewandten Platteseite auch gleichzeitig als Abstreifteil.

Der Hohlkörper des Füllteils ist mit einer Kartusche verbunden, die das Füll-oder Auftragsmaterial enthält und unter Pressdruck gesetzt wird, durch den das Füll- oder Auftragsmaterial in die Öffnungen und Löcher gelangt.

Das Füllmaterial kann eine leitfähige Füllmasse, wie z. B. eine Silberpaste, sein. Bevorzugt, weil kostengünstiger, sind jedoch auf Epoxydharzbasis beruhende Füllpasten als Füllmaterial vorgesehen.

Das Auftragsmaterial kann eine Lotpaste sein, über die später SMD-Bauteile auf der Leiterplatte aufgelötet werden.

Das Füllteil wird zumindest in einer Richtung motorisch angetrieben und über die Schablone bewegt. Wenn das Füllteil die Breite der mit Löchern versehenen Leiterplatte besitzt, ist dies genügend. Wenn das Füllteil schmaler ist, kann sie auch orthogonal dazu motorisch oder manuell bewegt werden.

Die Schablone ist vorzugsweise aus einer Metallplatte hergestellt. Sie kann aber auch aus einem Siebmaterial hergestellt sein, wie sie für einen Siebdruck verwendet wird.

Die Löcher können als Durchgangslöcher oder als Sacklöcher ausgeführt sein. Das Gegenhalteteil ist vorzugsweise als eine Platte mit Noppen ausgeführt, auf der die Leiterplatte gehalten ist und die Raum unter den Löchern bietet.

In einer anderen Ausführungsform ist das Gegenhalteteil aus einer porösen Platte gebildet. In einer weiteren Ausführungsform ist das Gegenhalteteil eine stabile Platte mit einer aufgelegten Papierbahn. Diese Ausführungsformen erlauben, dass das Füllmaterial durch die Durchgangslöcher gedrückt werden kann und ggf. in den Löchern befindliche Luft entweichen kann.

In einer bevorzugten Ausführungsform sind die Haltevorrichtung, das Füllteil und das Gegenhalteteil in einer Vakuumkammer angeordnet.

Aufgrund der Anordnung der Fülleinrichtung in der Vakuumkammer und des damit möglichen Evakuierens der in den Löchern in der Leiterplatte befindlichen Luft oder darin befindlichen Gases, kann das Füllmaterial die jeweils zu füllenden Löcher komplett einnehmen, wodurch Einschlüsse von Luft, Gas oder sonstigen Fremdkörpern vermieden sind.

Unter Vakuum können neben Durchgangslöchern auch Sacklöcher gefüllt werden, da keine Luft oder Gase eingeschlossen werden.

Das Verfahren zum Füllen von in Leiterplatten eingebrachten Löchern mit einem Füllmaterial oder zum Auftragen von Auftragsmaterial auf die Leiterplatte mittels einer vorbeschriebenen Anlage sieht vor, dass das Füllteil über die Leiterplatte bewegt wird und dabei anliegend an einer Seite der Leiterplatte die auf der Leiterplatte vorgesehenen Bearbeitungsbereiche unter Pressdruck bearbeitet werden. Dazu wird auf die Leiterplatte eine Schablone mit Öffnungen gelegt, durch die nur die Bearbeitungsbereiche freiliegen. Das Füllteil wird nacheinander über die Öffnungen geführt und dabei das Füll- oder Auftragsmaterial durch die Öffnungen in die freiliegenden Löcher oder auf die Auftragsbereiche gepresst.

Es sind sogenannten Rezepte vorgesehen. Nach den Dimensionen der Löcher oder Auftragbereiche und nach den eingesetzten Füll- oder Auftragsmaterialen werden der Pressdruck, die Temperatur des Materials und die Geschwindigkeit des Füllteils über der Schablone eingestellt.

Das Füllen von Löchern, insbesondere von Sacklöchern, wird wesentlich verbessert, wenn die Bearbeitung der leiterplatte unter Vakuum erfolgt.

Es ist vorgesehen, dass nach dem Füllen der Löcher die Leiterplatte getrocknet wird und damit das Füllmaterial aushärtet. Danach wird überstehendes Füllmaterial abgeschliffen und die Oberfläche der Leiterplatte plan geschliffen.

Die Erfindung wird im Folgenden anhand bevorzugter Ausführungsbeispiele mit Bezugnahme auf die Zeichnung erläutert. In der Zeichnung zeigen:
Fig. 1 eine schematische Darstellung einer Bearbeitungsanlage von Leiterplatten,
Fig. 2 eine Aufsicht auf eine Leiterplatte mit Schablone und Füllteil,
Fig. 3 einen Schnitt durch eine Leiterplatte mit Schablone und Füllteil,
Fig. 4 ein nach dem Verfahren bearbeitete Leiterplatte.

In der Zeichnung sind für wesensgleiche Teile die gleichen Bezugszeichen verwendet.

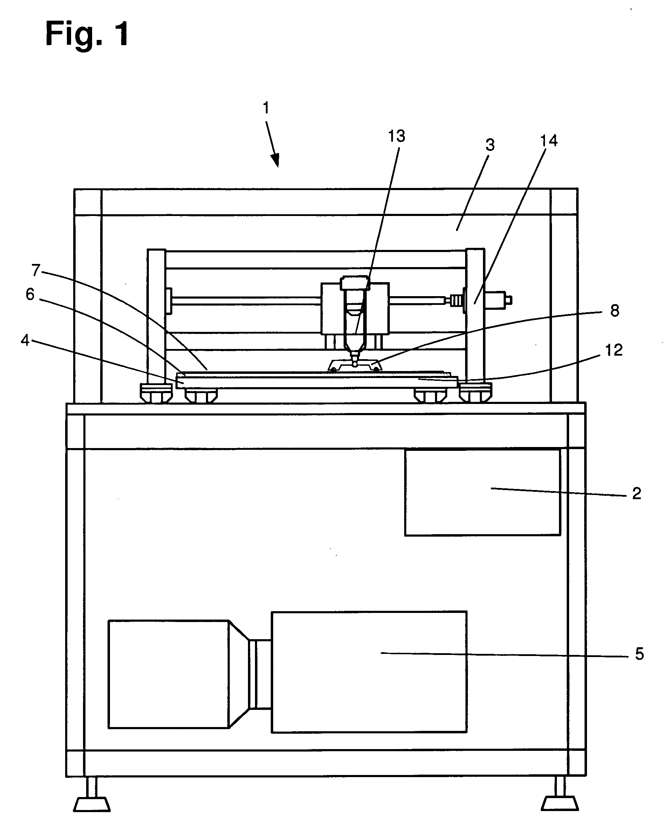

Gemäß Fig. 1 ist die Anlage 1 mit einer Halteeinrichtung 4 für die Leiterplatte 6 ausgestattet, die auf dem Gegenhalteteil 12 liegt. Auf der Leiterplatte 6 liegt die Schablone 7, auf die das Füllteil 8 gepresst wird. In das Füllteil 8 wird aus der Kartusche 13 das Füllmaterial gepresst und dann auf der mit der Schablone 7 abgedeckten Leiterplatte 6 verteilt.

Das Füllteil 8 wird mittels des X-Y-Fahrgestells 14 über der Schablone bewegt. Der Bearbeitungsteil der Anlage 1 ist in einer Vakuumkammer 3 untergebracht, die durch die Vakuumpumpe 5 evakuierbar ist.

Die Steuerung 2 übernimmt alle Steuervorgänge für die Bearbeitung, wie Verfahren des Füllteils 8, Aufbringen des Pressdrucks in der Kartusche 9, Evakuieren der Vakuumkammer 3 Heizen des Füllmaterials.

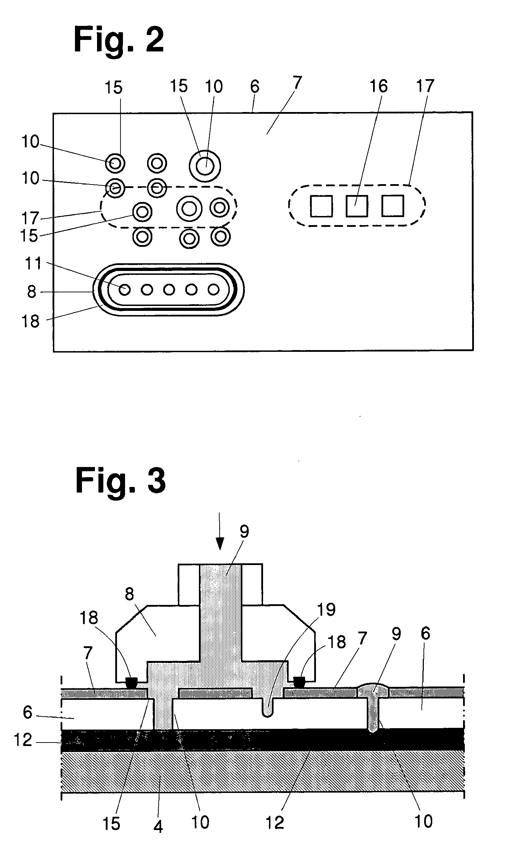

In Fig. 2 ist eine Leiterplatte 6 mit aufgelegter Schablone 7 als gestrichelte Umrandung dargestellt. In der Leiterplatte 6 befinden sich Löcher 10, die durch die Öffnungen 15 in der Schablone 7 zugänglich sind. Diese Löcher 10 können unterschiedlich groß sein und Durchgangslöcher oder Sacklöcher sein. Ebenso befinden sich Auftragsbereiche 16 in der Schablone 7, die etwa Lötpads bilden können.

Das Füllteil 8 bildet mit seinem Dichtring 18 einen Bearbeitungsbereich 17 auf der Schablone 7, in dem die freiliegenden Löcher 10 oder Auftragsbereiche 16 gleichzeitig bearbeitet werden. Dazu wird durch die Ausgangsöffnungen 11 Füll-oder Auftragsmaterial in das Füllteil gepresst.

Fig. 3 zeigt einen Ausschnitt durch eine Leiterplatte 6, die auf der Haltevorrichtung 4 mit dem Gegenhalteteil 12 aufliegt. Auf der Leiterplatte 6 liegt die Schablone 7, die bei den Löchern 10 Öffnungen 15 aufweist.

Auf der Schablone 7 bewegt sich das Füllteil 8, über das das Füllmaterial 9 in die Löcher 10 gepresst wird. Wenn die Anlage unter Vakuum arbeitet, können auch Sacklöcher 19 gefüllt werden.

Der Bearbeitungsbereich ist durch den Dichtring 18 an dem Füllteil 8 begrenzt. In dieser Fig. 2 wird die Füllung von zwei Löchern 10 dargestellt. Ein weiteres Loch 10 ist bereits gefüllt.

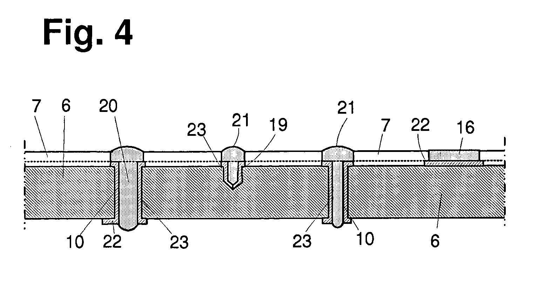

In Fig. 4 ist ein Schnitt durch eine bearbeitete Leiterplatte dargestellt.

Auf beiden Seiten befinden sich Kupferschichten 22, die bei den Löchern 10 und 19 mit einer Durchmetallisierung 23 verbunden sind. Die Löcher 10 und 19 sind bei den Öffnungen der Schablone 7 mit getrocknetem Füllmaterial 20 gefüllt, das durch das Trocknen Kegel 21 ausbildet. Die nach dem Abnehmen der Schablone 7 überstehenden Kegel 21 können bis auf die Kupferschicht 22 plan abgeschliffen werden, hier durch eine gestrichelte Linie dargestellt.

Auf der Kupferschicht 22 ist ein aufgetragenes Lötpad bei einem Auftragbereich 16 der Schablone 7 vorhanden.

### Bezugszeichenliste

- 1: Anlage
- 2: Steuerung
- 3: Vakuumkammer
- 4: Haltevorrichtung
- 5: Vakuumpumpe
- 6: Leiterplatte
- 7: Schablone
- 8: Füllteil
- 9: Füllmaterial
- 10: Löcher
- 11: Ausgangsöffnung
- 12: Gegenhalteteil
- 13: Kartusche
- 14: X-Y-Fahrgestell für das Füllteil
- 15: Öffnung
- 16: Auftragsbereich
- 17: Bearbeitungsbereich
- 18: Dichtring
- 19: Sackloch
- 20: getrocknetes Füllmaterial
- 21: Kegel
- 22: Kupferschicht
- 23: Durchmetallisierung

## Patentansprüche

1. Anlage (1) zum Bearbeiten von Leiterplatten (6), die das Füllen von eingebrachten Löchern (10) mit einem Füllmaterial (9) oder das Auftragen von Auftragsmaterial erlaubt, umfassend eine Haltevorrichtung (4) zum Halten der Leiterplatte (6), ein Füllteil (8) zum Einbringen des Füll- oder Auftragsmaterials (9) und ein auf der dem Füllteil (8) gegenüberliegenden Seite der Leiterplatte (6) befindliches Gegenhalteteil (12), wobei das Füllteil (8) über die Leiterplatte bewegbar ist und dabei, abgedichtet an einer Seite der Leiterplatte(6) anliegend, die auf der Leiterplatte (6) vorgesehenen Bearbeitungsbereiche unter Pressdruck bearbeitet, wobei die Leiterplatte (6) waagerecht in der Halteeinrichtung (4) gehalten ist und auf der Leiterplatte eine Schablone (7) liegt, die bei den Bearbeitungsbereichen (17) Öffnungen (15) aufweist, so dass nur die durch die Öffnungen (15) freiliegenden Löcher (10) oder Auftragsbereiche (16) gefüllt werden, **dadurch gekennzeichnet, dass** das Gegenhalteteil (12) als Platte ausgeführt ist, die porös ist oder mit Abstandsnoppen versehen ist oder auf der eine Papierlage aufgelegt ist.

2. Anlage nach Anspruch 1, **dadurch gekennzeichnet, dass** das Füllteil (8) einen Hohlkörper besitzt, welcher zur Aufnahme des Füll- oder Auftragsmaterials (9) vorgesehen ist und welcher eine oder mehrere Ausgangsöffnungen (11) aufweist, sowie eine die Ausgangsöffnungen (11) umgebende Dichtung (18), mit der das Füllteil (8) den Zwischenraum zwischen der/den Ausgangsöffnungen (11) und der Schablone (7) abdichtet.

3. Anlage nach Anspruch 2, **dadurch gekennzeichnet, dass** das Füllteil (8) schmaler ist als die Breite der Schablone (7).

4. Anlage nach Anspruch 3, **dadurch gekennzeichnet, dass** das Füllteil (8) motorisch in zwei Richtungen über die Schablone (7) bewegbar ist.

5. Anlage nach Anspruch 1, **dadurch gekennzeichnet, dass** das Füllmaterial (9) eine leitfähige Paste oder ein Epoxydharz ist.

6. Anlage nach Anspruch 1, **dadurch gekennzeichnet, dass** das Auftragsmaterial (9) eine Lotpaste ist.

7. Anlage nach Anspruch 1, **dadurch gekennzeichnet, dass** die Schablone (7) aus einer Metallplatte oder einem Siebmaterial hergestellt ist.

8. Anlage nach Anspruch 1, **dadurch gekennzeichnet, dass** die Löcher (10) Durchgangslöcher oder Sacklöcher (19) sind.

9. Anlage nach Anspruch 1, **dadurch gekennzeichnet, dass** Haltevorrichtung (4), das Füllteil (8) und das Gegenhalteteil (12) in einer Vakuumkammer (3) angeordnet sind.

10. Verfahren zum Füllen von in Leiterplatten (6) eingebrachten Löchern (10) mit einem Füllmaterial (9) oder zum Auftragen von Auftragsmaterial mittels einer Anlage (1) nach einem der vorstehenden Ansprüche, bei dem das Füllteil (8) über die Schablone (7) bewegt wird und dabei anliegend an einer Seite der Leiterplatte (6) die auf der Leiterplatte (6) vorgesehenen Bearbeitungsbereiche (17) unter Pressdruck bearbeitet werden, **dadurch gekennzeichnet, dass** auf die Leiterplatte (6) eine Schablone (7) mit Öffnungen (15) gelegt wird, durch die nur die Bearbeitungsbereiche (17) freiliegen,
das Füllteil (8) nacheinander über die Öffnungen (15) geführt wird,
und das Füll- oder Auftragsmaterial (9) durch die Öffnungen (15) in die freiliegenden Löcher (10) oder auf die Auftragsbereiche (16) gepresst wird.

11. Verfahren nach Anspruch 10, **dadurch gekennzeichnet, dass** der Pressdruck auf die Dimensionen der Löcher (10) eingestellt wird.

12. Verfahren nach Anspruch 10, **dadurch gekennzeichnet, dass** die Geschwindigkeit des Füllteils (8) auf der Schablone (7) eingestellt wird.

13. Verfahren nach Anspruch 10, **dadurch gekennzeichnet, dass** die Löcher (10) unter Vakuum gefüllt werden.

14. Verfahren nach Anspruch 10, **dadurch gekennzeichnet, dass** nach dem Füllen die Leiterplatte (6) getrocknet wird und das Füllmaterial (9) aushärtet.

15. Verfahren nach Anspruch 14, **dadurch gekennzeichnet, dass** überstehendes Füllmaterial (9) abgeschliffen und die Oberfläche der Leiterplatte (6) plan geschliffen wird.

## Claims

1. System (1) for processing printed circuit boards (6), which permits filling previously machined holes (10) with a filler material (9) or applying application material, comprising a retaining device (4) for holding the printed circuit board (6), a filling unit (8) for feeding the filler or application material (9) and a back rest unit (12) located on the side of the printed circuit board (6) opposite the filling unit (8), wherein the filling unit (8) can be moved across the printed circuit board and, while it bears against and is sealed against one side of the printed circuit board (6), processes processing areas provided on the printed circuit board (6) under compacting pressure, wherein the printed circuit board (6) is held horizontally in the retaining device (4), and a template (7) is placed on the printed circuit board, which has openings (15) at the processing areas (17), so that only the holes (10) or application areas (16) exposed by the openings (15) are filled, **characterized in that**
the back rest unit (12) is a plate that is porous or equipped with spacer knobs or covered with a paper web.

2. System according to claim 1, **characterized in that** the filling unit (8) has a hollow body to hold the filler or application material (9), with one or more outlet openings (11), and a seal (18) surrounding the outlet openings (11), by means of which the filling unit (8) seals the gap between the outlet opening(s) (11) and the template (7).

3. System according to claim 2, **characterized in that** the filling unit (8) is narrower than the width of the template (7).

4. System according to claim 3, **characterized in that** the filling unit (8) can be moved across the template (7) in two directions by a motor.

5. System according to claim 1, **characterized in that**, the filler material (9) is a conductive paste or an epoxy resin.

6. System according to claim 1, **characterized in that** the application material (9) is a soldering paste.

7. System according to claim 1, **characterized in that** the template (7) is made of a metal plate or of a screen material.

8. System according to claim 1, **characterized in that** the holes (10) are through holes or blind holes (19).

9. System according to claim 1, **characterized in that** the retaining device (4), the filling unit (8) and the back rest unit (12) are arranged in a vacuum chamber (3).

10. Method for filling holes (10) in printed circuit boards (6) with a filler material (9), or for applying application material, by means of a system (1) according to one of the above claims, in which the filling unit (8) is moved across the template (7), while it bears against one side of the printed circuit board (6), and processes the processing areas (17) provided on the printed circuit board (6) under compacting pressure, **characterized in that** a template (7) with openings (15) is placed on the printed circuit board (6) which exposes only the processing areas (17), that the filling unit (8) is guided across the openings (15) successively, and that the filler or application material (9) is pressed through the openings (15) into the exposed holes (10) or onto the application areas (16).

11. Method according to claim 10, **characterized in that** the compacting pressure is adjusted according to the dimensions of the holes (10).

12. Method according to claim 10, **characterized in that** the speed of the filling unit (8) on the template (7) is adjusted.

13. Method according to claim 10, **characterized in that** the holes (10) are filled under vacuum.

14. Method according to claim 10, **characterized in that** the printed circuit board (6) is dried after the filling process, and the filler material (9) hardens

15. Method according to claim 14, **characterized in that** protruding filler material (9) is abraded and the surface of the printed circuit board (6) is levelled.

## Revendications

1. Installation (1) destinée à traiter des plaquettes de circuits imprimés (6), permettant le remplissage des trous (10) préalablement usinés avec un matériau de remplissage (9) ou l'application de matériau de revêtement, comprenant un dispositif de maintien (4) pour maintenir la plaquette (6), une section de remplissage (8) pour amener le matériau de remplissage ou de revêtement (9) et une pièce d'arrêt homologue (12) située sur la plaquette (6) au niveau du côté opposée de la section de remplissage (8), dans lequel la section de remplissage (8) est mobile par rapport au plaquette et ainsi, scellée au côté de la plaquette (6), les régions d'usinage prévues sur la plaquette (6) sont usinées sous pression appliquée, dans lequel la plaquette (6) est maintenue horizontalement dans le dispositif de maintien (4), et un modèle (7) est situé sur la plaquette, comportant au niveau des régions d'usinage (17) des ouvertures (15) de telle sorte que seulement des trous (10) exposées à travers les ouvertures (15) ou les régions de revêtement (16) peuvent être remplis, **caractérisée en ce que** la pièce d'arrêt (12) est une plaque qui est poreuse ou munie de picots écarteurs ou recouverte d'une feuille de papier.

2. Installation selon la revendication 1, **caractérisée en ce que** la section de remplissage (8) a un corps creux pour contenir le matériau de remplissage ou de revêtement (9), avec une ou plusieurs ouvertures de sortie (11), et un joint d'étanchéité (18) entourant les ouvertures de sortie (11), au moyen de laquelle la section de remplissage (8) scelle l'écart entre la/les ouverture(s) de sortie (11) et le modèle (7).

3. Installation selon la revendication 2, **caractérisée en ce que** la section de remplissage (8) est plus étroite que la largeur du modèle (7).

4. Installation selon la revendication 3, **caractérisée en ce que** la section de remplissage (8) peut être déplacée à travers le modèle (7) dans deux directions par un moteur.

5. Installation selon la revendication 1, **caractérisée en ce que**, le matériau de remplissage (9) est une pâte conductrice ou d'une résine époxy.

6. Installation selon la revendication 1, **caractérisée en ce que** le matériau de revêtement (9) est une pâte à braser.

7. Installation selon la revendication 1, **caractérisée en ce que** le modèle (7) est constitué d'une plaque métallique ou d'un écran de sérigraphie.

8. Installation selon la revendication 1, **caractérisée en ce que** les trous (10) sont des trous traversant ou des trous borgnes (19).

9. Installation selon la revendication 1, **caractérisée en ce que** le dispositif de maintien (4), la section de remplissage (8) et la pièce d'arrêt (12) sont disposés dans une chambre à vide (3).

10. Procédé pour le remplissage de trous (10) dans des plaquettes de circuits imprimés (6) avec un matériau de remplissage (9), ou pour l'application d'un matériau de revêtement, au moyen d'une installation (1) selon l'une quelconque des revendications précédentes, dans lequel la section de remplissage (8) est déplacée à travers le modèle (7), prenant appui contre une côté de la plaquette (6), et usinant les régions d'usinage (17) prévues sur la plaquette (6) sous une pression de compactage, **caractérisé en ce qu'**un modèle (7) est placé sur la plaquette (6) ayant des ouvertures (15) qui exposent uniquement les régions d'usinage (17), que la section de remplissage (8) est guidée à travers les ouvertures (15) successivement, et que le matériau de remplissage ou de revêtement (9) est pressé à travers les ouvertures (15) dans les trous exposés (10) ou sur les régions de revêtement (16).

11. Procédé selon la revendication 10, **caractérisé en ce que** la pression de compactage est ajustée selon les dimensions des trous (10).

12. Procédé selon la revendication 10, **caractérisé en ce que** la vitesse de la section de remplissage (8) sur le modèle (7) est ajustée.

13. Procédé selon la revendication 10, **caractérisé en ce que** les trous (10) sont remplis sous vide.

14. Procédé selon la revendication 10, **caractérisé en ce que** la plaquette (6) est séchée après le procédé de remplissage, et le matériau de remplissage (9) durcit.

15. Procédé selon la revendication 14, **caractérisé en ce que** tout matériau de remplissage faisant saillie (9) est abrasé et la surface de la plaquette (6) est nivelée.
